(19) Europäisches Patentamt / European Patent Office / Office européen des brevets

(11) **EP 1 488 504 B1**

(12) **EUROPEAN PATENT SPECIFICATION**

(45) Date of publication and mention
of the grant of the patent:
**24.07.2019 Bulletin 2019/30**

(51) Int Cl.:
**H02P 7/32** *(2006.01)*    **H02P 23/14** *(2006.01)*

(21) Application number: **03745679.5**

(22) Date of filing: **28.03.2003**

(86) International application number:
**PCT/US2003/009972**

(87) International publication number:
**WO 2003/084044 (09.10.2003 Gazette 2003/41)**

(54) **MOTOR CURRENT RECONSTRUCTION VIA DC BUS CURRENT MEASUREMENT**

MOTORSTROMREKONSTRUKTION ÜBER GLEICHSTROMBUSSTROMMESSUNG

RECONSTRUCTION DE COURANT DE MOTEUR PAR UNE MESURE DE COURANT DE BUS CC

(84) Designated Contracting States:
**AT BE BG CH CY CZ DE DK EE ES FI FR GB GR HU IE IT LI LU MC NL PT RO SE SI SK TR**

(30) Priority: **28.03.2002 US 368860 P**
**27.03.2003 US 402107**

(43) Date of publication of application:
**22.12.2004 Bulletin 2004/52**

(73) Proprietor: **Infineon Technologies Americas Corp.**
**El Segundo, CA 90245 (US)**

(72) Inventors:
• **HO, Eddy Ying Yin**
**Torrance, CA 90505 (US)**
• **TAKAHASHI, Toshio**
**Rancho Palos Verdes, CA 90275 (US)**

(74) Representative: **Westphal, Mussgnug & Partner**
**Patentanwälte mbB**
**Werinherstrasse 79**
**81541 München (DE)**

(56) References cited:
EP-A2- 0 691 730    JP-A- H09 172 781
JP-A- 2001 327 173    US-A- 4 847 743
US-A- 6 005 783    US-A1- 2001 008 371
US-B1- 6 590 794    US-B1- 6 653 812

**Description**

<u>RELATED APPLICATION</u>

The application is based on and claims benefit of United States Provisional Application No. 60/368,860, filed on March 28, 2002, entitled Motor Current Reconstruction Via DC Bus Current Measurement, to which a claim of priority is hereby made.

<u>BACKGROUND OF THE INVENTION</u>

1. <u>Field of the Invention</u>

The present invention relates generally to motor current feedback measurements, and relates more specifically to a computational reconstruction of motor current obtained through measurement of a DC bus current.

2. <u>Description of Related Art</u>

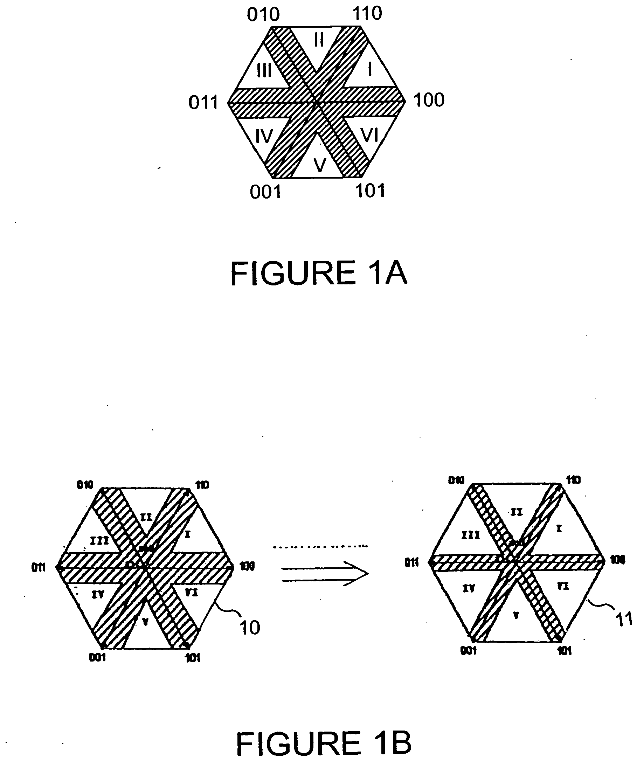

Inverters for three phase motor drives are well known in the industry. Typically, a DC bus supplies switched power to different phases of an AC motor. A design approach used to supply switching commands and sequences to the inverter involves the use of space vector modulation. For example, a switch vector plane is illustrated in Fig. 1 with specific switch states noted at the vertices of the hexagon.
With this type of motor control, it is desirable to accurately measure motor phase current to provide a high performance control. However, it is often difficult to accurately measure motor phase current over wide current and temperature ranges. For example, Hall effect sensors can be used, but are inherently bulky and costly. In a pulse width modulated (PWM) inverter drive system, motor phase current can be determined from measurement of the DC bus current when non-zero basic vectors are used. Each basic vector is assigned a specific time in a PWM cycle to generate the command voltage vector. However, if a basic vector is used only for a very short period of time, motor phase current cannot be directly determined from the DC bus current. This lack of observability of motor phase current is due to practical considerations in the implementation of the PWM inverter drive system. For example, time delays caused by A/D converter sample and hold times, slewing of voltage during turn on, and other delay factors prevent the effects of basic vectors used for a very short time from being observed.
In the space vector plane shown in Fig. 1A, the non-observable regions are illustrated as being located along the borders of the sections of the space vector plane. Without being able to observe motor phase currents during these control periods, it is difficult to achieve a robust and high performance motor drive.
US 4 847 743 A discloses a PWM inverter system which includes a first means for producing switching signals for 3-phase modulation by which switching elements for each phase make a switching operation, a second means for producing switching signals for 2-phase modulation by which a switching operation for one phase is unnecessary, and a change-over means for changing over the two means in response, for example, to a magnitude value of the inverter output voltage.

<u>SUMMARY OF THE INVENTION</u>

The present invention provides an algorithm for the reconstruction of motor currents from measurement of DC bus current. The non-observable operation of motor phase current is restricted to a much smaller domain with the use of the reconstructing algorithm. 2-phase space vector modulation permits the minimum time for an observable effect of a basic vector to be decreased. In practical application, the time constraint related to non-observability is cut in half. By reducing this minimum time, the available time for measurement of phase current according to this technique is doubled. When the voltage vector angle is large than 30 °, the zero vector 111 is used instead of 000. By using the different zero vector, a switched phase pulse time is maximized.
When 2-phase space vector modulation is used, and motor current exceeds a certain threshold level, dead time need not be inserted and the time constraint can be further reduced.
When command voltage falls inside the non-observable domains, the command voltage vector is formed from two vectors generated in two PWM periods. One generated vector is a voltage vector having a phase equal to 30° and a magnitude equal to two times the width of the non-observable section. Use of this vector insures the observability of two of the three motor phase currents. The second vector is added to form the resulting command voltage vector that falls inside the non-observable domain. The time average of the two combined vectors are equal to the time average of the command voltage vector. Using the combination of the two vectors permits the controller execution cycle to be reduced by half.

## BRIEF DESCRIPTION OF THE DRAWINGS

The present invention is described in detail below, with reference to the accompanying drawings having appropriate reference numeral designators, in which:

Fig. 1A illustrates a voltage space vector plane with conventional non-observable zones;
Fig. 1B illustrates a modified voltage space vector plane according to the present invention;
Fig. 2 illustrates a reduced non-observable zone through 2-phase commutation;
Fig. 3 illustrates a current sampling technique according to the present invention; and
Fig. 4 illustrates the insertion of a known voltage vector to obtain a reference command voltage vector.

## DETAILED DESCRIPTION OF THE PREFERRED EMBODIMENTS

The present invention provides an algorithm to reconstruct 3-phase motor current information from measurement of a DC bus current supply. A voltage space vector plane 10, as illustrated in Fig. 1B, contains non-observable regions near sector borders. According to the present invention, a voltage space vector plane 11 is produced with reduced non-observable zones.

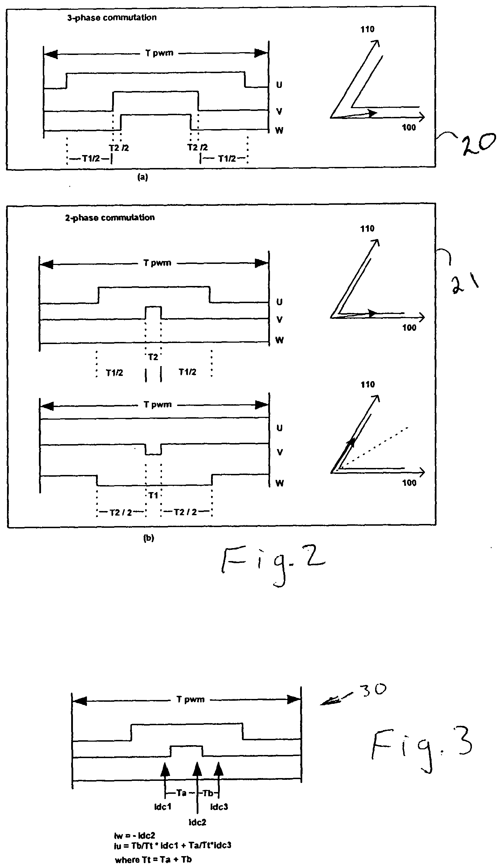

Referring to Fig. 2(a), a conventional 3-phase inverter provides a 3-phase voltage space vector PWM modulation. In Fig. 2(b), a same command voltage can be formed using a 2-phase voltage space vector PWM, as illustrated in commutation diagram 21. According to the 2-phase vector modulation, a minimum time constraint for non-observability is cut in half.

In a two level PWM inverter drive system, eight possible basic voltage vectors can be produced, and any desired command voltage vector can be formed by the eight basic voltage vectors. The desired command voltage vector is limited by the maximum output voltage of the inverter, as determined by the DC bus voltage level. In a PWM inverter drive system, motor phase current information can be determined from the DC bus current when non-zero basic vectors are used. Each basic vector is assigned a specific time in a PWM cycle to generate a command voltage vector. If the command voltage vector is used only for a very short period of time, the motor current cannot be observed from the DC bus current. The shortness of this time constraint results from time delays associated with A/D conversion, including sample and hold times, in addition to voltage slewing resulting from device turn on. It is this time constraint that forms the non-observable regions in the voltage space vector plane illustrated in Fig. 1.

Referring again to Fig. 2(a), a command voltage vector is shown in non-observable region of sector 1. In this instance, all three phases of the motor are PWM driven in a PWM cycle Tpwm. The total time T2 occurs in two different spots in PWM cycle Tpwm.

Referring now to Fig. 2(b), a non-observable region is reduced through the use of a 2-phase voltage space vector modulation. The same command voltage can be formed by the 2-phase PWM in Fig. 2(b), as is formed in the system of Fig. 2(a). However, in the 2-phase voltage space vector modulation, the non-observable time constraint period is cut in half. The total T2 time is localized in one spot. Accordingly, the available time for measurement of current is doubled. When the voltage angle is larger than 30°, the zero vector 111 is used instead of the zero vector 000 to maximize T1 time.

With the use of a 2-phase voltage space vector modulation, a further reduction in the time constraint can be achieved. When motor current is higher than a given threshold, the need to insert dead time is eliminated. Typically, the time constraint can be written as a minimum time Tmin as follows:

$$Tmin = Td + T(dv/dt) + T(A/D)$$

$$where \begin{bmatrix} Td = \begin{bmatrix} Tdeadtime & abs(i) > Threshold \\ 0 & abs(i) < Threshold \end{bmatrix} \\ T(A/D) \quad A/D \text{ converter sample/hold time} \\ T(dv/dt) \quad \text{Power switching device slew time} \end{bmatrix}$$

Accordingly, when Td is equal to zero, Tmin is reduced accordingly.

Referring now to Fig. 3, the DC bus current is sampled three times every PWM cycle. In Fig. 3, samples idc1and idc3 are taken from the same motor phase, but at different time instance. Current samples idc1 and idc3 are computed based on the equations shown in Fig. 3 to provide a timing synchronization with sample idc2.

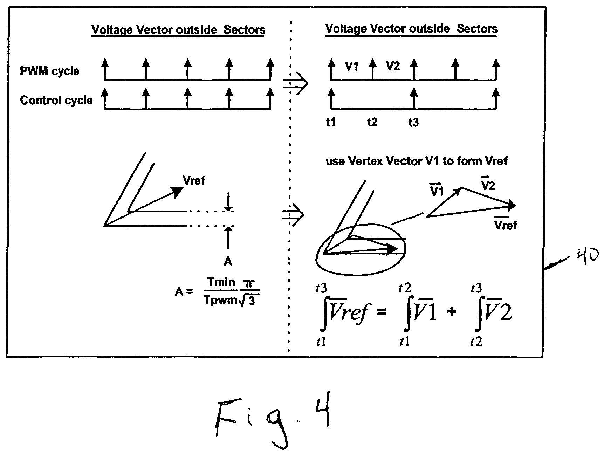

Referring now to Fig. 4, the insertion of a known voltage vector is illustrated in diagram 40. The insertion of the voltage vector is used to form a command voltage vector Vref. When the command voltage is inside the non-observable sector bands, the command voltage vector is formed by two vectors generated in two PWM periods. Voltage vector V1 has a phase equal to 30° and a magnitude equal to two times the non-observable sector width A. By forming vector V1 according to these constraints, observation of two motor phase currents is insured. Vector V2 is added to vector V1 to form the resulting command voltage vector Vref. The time average of V1 plus V2 is equal to the time average of Vref, as illustrated in Fig. 4. By forming the command voltage vector with vectors V1 and V2, the controller execution cycle is reduced by half when the command voltage enters the non-observable sector.

Although the present invention has been described in relation to particular embodiments thereof, many other variations and modifications and other uses will become apparent to those skilled in the art. It is preferred, therefore, that the present invention be limited not by the specific disclosure herein, but only by the appended claims.

## Claims

1. A method for reconstructing motor phase current in an inverter drive system for a motor, comprising:

   measuring currents applied on a DC bus supplying power to the inverter to obtain an indication of electrical phase current in the motor;
   determining when a three phase PWM inverter modulation results in motor switching that results in inability to determine the motor phase current through the DC bus current measurement; and
   dynamically changing from three phase PWM modulation to two phase PWM modulation for a switching cycle of the inverter drive system to reduce the time interval when the motor phase current is not determinable through the DC bus current measurement.

2. The method according to claim 1, wherein the step of changing from three phase PWM modulation to two phase PWM modulation comprises changing from three phase modulation to two phase modulation for any switching cycle that is determined to include a switching event where the motor phase current is not determinable through measurement of the DC bus current.

3. The method according to claim 1, further comprising changing from three phase modulation to two phase modulation when the motor is running at a relatively high speed.

4. The method according to claim 1, further comprising eliminating a deadtime insertion when motor current is higher than a given threshold, thereby reducing the time interval during which motor phase current is not determinable through measurement of DC bus current.

5. The method according to claim 1, further comprising using an alternate zero vector when a voltage angle is larger than 30° to maximize the time for current measurement.

6. The method according to claim 5, wherein zero vector 111 is used as the alternate zero vector.

## Patentansprüche

1. Verfahren zur Motorphasenstromrekonstruktion in einem Wechselrichter-Antriebssystem für einen Motor, umfassend:

   Messen von Strömen, die an einen DC-Bus, der den Wechselrichter mit Strom versorgt, angelegt werden, um eine Angabe des elektrischen Phasenstroms in dem Motor zu erhalten;
   Bestimmen, wann eine dreiphasige PWM-Wechselrichtermodulation zu einer Motorschaltung führt, die zu einer Unfähigkeit führt, den Motorphasenstrom durch die DC-Busstrommessung zu bestimmen; und
   dynamisches Wechseln von einer dreiphasigen PWM-Modulation zu einer zweiphasigen PWM-Modulation für einen Schaltzyklus des Wechselrichter-Antriebssystems, um das Zeitintervall zu reduzieren, in dem der Motorphasenstrom nicht durch die DC-Busstrommessung bestimmbar ist.

2. Verfahren gemäß Anspruch 1, wobei der Schritt des Wechselns von einer dreiphasigen PWM-Modulation zu einer zweiphasigen PWM-Modulation das Wechseln von einer dreiphasigen PWM-Modulation zu einer zweiphasigen PWM-Modulation für jeden Schaltzyklus, der bestimmt ist, um einen Schaltvorgang zu umfassen, in dem der Motorphasenstrom nicht durch die DC-Busstrommessung bestimmbar ist, umfasst.

3. Verfahren gemäß Anspruch 1, weiter umfassend Wechseln von einer dreiphasigen PWM-Modulation zu einer zweiphasigen PWM-Modulation, wenn der Motor mit einer relativ hohen Geschwindigkeit läuft.

4. Verfahren gemäß Anspruch 1, weiter umfassend Eliminieren einer Totzeiteinfügung, wenn der Motorstrom höher als eine gegebene Schwelle ist, wodurch das Zeitintervall, in dem der Motorphasenstrom nicht durch die DC-Busstrommessung bestimmbar ist, reduziert wird.

5. Verfahren gemäß Anspruch 1, weiter umfassend Verwenden eines abwechselnden Nullvektors, wenn der Spannungswinkel breiter als 30° ist, um die Zeit für die Strommessung zu maximieren.

6. Verfahren gemäß Anspruch 5, wobei ein Nullvektor 111 als der abwechselnde Nullvektor verwendet wird.


**Revendications**

1. Procédé de reconstruction de courant de phase de moteur dans un système d'entraînement d'onduleur pour un moteur, comprenant :

   la mesure de courants appliqués à un bus cc alimentant l'onduleur en énergie pour obtenir une indication du courant de phase électrique dans le moteur ;
   le fait de déterminer quand une modulation d'onduleur PWM à trois phases entraîne une commutation du moteur qui entraîne une incapacité à déterminer le courant de phase du moteur par la mesure de courant de bus cc ; et
   le changement dynamique d'une modulation PWM à trois phases à une modulation PWM à deux phases pour un cycle de commutation du système d'entraînement de l'onduleur afin de réduire l'intervalle de temps pendant lequel le courant de phase du moteur n'est pas déterminable par la mesure de courant de bus cc.

2. Procédé selon la revendication 1, dans lequel l'étape de changement de la modulation PWM à trois phases à la modulation PWM à deux phases comprend le changement d'une modulation PWM à trois phases à une modulation PWM à deux phases pour n'importe quel cycle de commutation qui est déterminé pour inclure un événement de commutation dans lequel le courant de phase du moteur n'est pas déterminable par la mesure de courant de bus cc.

3. Procédé selon la revendication 1, comprenant en outre le changement d'une modulation PWM à trois phases à une modulation PWM à deux phases quand le moteur fonctionne à une vitesse relativement haute.

4. Procédé selon la revendication 1, comprenant en outre l'élimination de l'insertion d'un temps mort quand le courant du moteur est supérieur à un seuil donné, réduisant par-là l'intervalle de temps durant lequel le courant de phase du moteur n'est pas déterminable par la mesure de courant de bus cc.

5. Procédé selon la revendication 1, comprenant en outre l'utilisation d'un vecteur nul alternatif quand l'angle de tension est supérieur à 30° afin de maximiser le temps pour la mesure de courant.

6. Procédé selon la revendication 5, dans lequel le vecteur nul 111 est utilisé comme vecteur nul alternatif.

FIGURE 1A

FIGURE 1B

3-phase commutation

T pwm

U
V
W

T2 /2    T2 /2
—T1/2—|          |— T1/2—

(a)

110

100

2-phase commutation

T pwm

U
V
W

T2
T1/2    | |    T1/2

110

100

T pwm

U
V
W

T1
—T2 / 2—    —T2 / 2—

(b)

110

100

Fig. 2

T pwm

Ta — Tb
Idc1    Idc3
Idc2

Iw = - Idc2
Iu = Tb/Tt * Idc1 + Ta/Tt*Idc3
where Tt = Ta + Tb

Fig. 3

7

**Voltage Vector outside Sectors**

PWM cycle

Control cycle

Vref

$$A = \frac{Tmin}{Tpwm} \frac{\pi}{\sqrt{3}}$$

**Voltage Vector outside Sectors**

V1   V2

t1    t2    t3

**use Vertex Vector V1 to form Vref**

$\overline{V1}$   $\overline{V2}$

$\overline{Vref}$

$$\int_{t1}^{t3} \overline{Vref} = \int_{t1}^{t2} \overline{V1} + \int_{t2}^{t3} \overline{V2}$$

Fig. 4

**EP 1 488 504 B1**

## Patent documents cited in the description

- US 60368860 B
- US 4847743 A